# EUROPEAN PATENT APPLICATION

(11) **EP 2 757 865 A1**
(43) Date of publication of application: **23.07.2014**
(21) Application number: 11872250.3
(22) Date of filing: 12.09.2011
(51) Int. Cl.: H05K 3/46, H05K 3/28

(54) **METHOD FOR MANUFACTURING SUBSTRATE WITH BUILT-IN COMPONENT AND SUBSTRATE WITH BUILT-IN COMPONENT USING SAME**

(71) Applicant: Meiko Electronics Co., Ltd., Ayase-shi, Kanagawa 252-1104 (JP)
(72) Inventor: MATSUMOTO, Tohru, Ayase-shi Kanagawa 252-1104 (JP); TODA, Mitsuaki, Ayase-shi Kanagawa 252-1104 (JP); IMAMURA, Yoshio, Ayase-shi Kanagawa 252-1104 (JP)
(74) Representative: Epping - Hermann - Fischer
(86) International application number: PCT/JP2011/070701
(87) International publication number: WO 2013/038468

(57) **Abstract**

A method of manufacturing a component-embedded substrate comprises an adhesive layer forming step of forming an adhesive layer 10 on a metal layer 12 formed on a supporting plate 11, and a component mounting step of mounting an electric or electronic component 3 on the adhesive layer 10, wherein the component 3 includes a component main body 3a and a protrusion 3b that protrudes beyond the component main body 3a toward the adhesive layer 10, the adhesive layer 10 formed in the adhesive layer forming step includes at least a first adhesive body 10a and a second adhesive body 10b, the first adhesive body 10a is formed only at a position corresponding to the protrusion 3b, the second adhesive body 10b is formed in an area corresponding to the whole of the surface of the component 3 facing the adhesive layer 10 after the first adhesive body 10a is cured, and the component 3 is mounted with the protrusion 3b aligned with the first adhesive body 10a in the component mounting step.

## Description

### Technical Field

The present invention relates to a method of manufacturing a component-embedded substrate and a component-embedded substrate manufactured by the same.

### Background Art

There are various methods of manufacturing a component-embedded substrate (see Patent Document 1, for example). The method disclosed in Patent Document 1 includes forming an adhesive layer on a copper foil with a dispenser or by a printing technique, mounting a component to be embedded on the adhesive layer, curing the adhesive layer to fix the component. The component is then embedded in an insulating substrate by laminating press, and a via extending from the outside to a terminal on the component is formed by laser beam machining. The via is then plated to form a conductive via, which provides an electrical connection to the terminal.

However, the method described above has a disadvantage that a void (a cavity) can be formed in the adhesive layer. The void can expand in the subsequent reflow step or cause a peeling or a short circuit. In particular, if the component has recesses and projections on the surface in contact with the adhesive layer, more voids can be formed. Such an increased number of voids affect the formability, the connection reliability or the insulation properties of the conductive via.

### Prior Art Document

### Patent Document

Patent Document 1: Japanese Patent Laid-Open No. 2010-27917

### Summary of the Invention

### Problem to be Solved by the Invention

The present invention has been devised in view of the disadvantages of the conventional technique described above, and an object of the present invention is to provide a method of manufacturing a component-embedded substrate that can prevent formation of a void with reliability, in particular, even if a component to be embedded has recesses and projections, and a component-embedded substrate manufactured by the same method.

### Means for Solving the Problem

The present invention provides a method of manufacturing a component-embedded substrate, comprising: an adhesive layer forming step of forming an adhesive layer on a metal layer formed on a supporting plate; and a component mounting step of mounting an electric or electronic component on said adhesive layer, wherein said component includes a component main body and a protrusion that protrudes beyond the component main body toward said adhesive layer, the adhesive layer formed in said adhesive layer forming step includes at least a first adhesive body and a second adhesive body, said first adhesive body is formed only at a position corresponding to said protrusion, the second adhesive body is formed in an area corresponding to the whole of the surface of said component facing said adhesive layer after said first adhesive body is cured, a part of said adhesive layer formed by said first adhesive body is a projection part, a part of said adhesive layer formed by said second adhesive body alone is a recess part, which has a lower height than said projection part, and said component is mounted with said protrusion aligned with said first adhesive body in said component mounting step.

Preferably, said first adhesive body and said second adhesive body are made of a same material.

Preferably, said first adhesive body and said second adhesive body are made of different materials.

Furthermore, said protrusion is a terminal, and the method of manufacturing a component-embedded substrate according to the present invention further comprises: a laminating step of laminating an insulating substrate, which is to serve as an insulating layer for said component, to embed said component in said insulating substrate, the laminating step being performed after said component mounting step; a via forming step of removing said supporting plate and forming a via that penetrates through said metal layer and said adhesive layer and reaches said terminal; a plating step of depositing a plating on a surface of said metal layer and a surface of said via; and a patterning step of forming a conductive pattern including said metal layer.

Preferably, said supporting plate used in said adhesive layer forming step is an aluminum plate, and said metal layer is a copper foil applied to said aluminum plate.

Preferably, said supporting plate used in said adhesive layer forming step is a stainless steel plate, and said metal layer is a copper plating foil deposited on said stainless steel plate.

Preferably, a plurality of either or both of semiconductor components having a plurality of electrodes and passive components having a plurality of electrodes are mounted in said component mounting step.

Preferably, not only said insulating layer but also a circuit board including a conductive circuit, a conductive via or a conductive through-hole or a combination thereof is disposed at a side of said component in said laminating step, and a connection via that electrically connects said conductive layer and said circuit board to each other is formed in said via forming step.

Preferably, said connection via formed in said via forming step is a filled via.

Preferably, a connection provided by said connection via formed in said via forming step is of an any-layer structure.

Preferably, said connection via formed in said via forming step has a diameter equal to or larger than a diameter of said via.

The present invention further provides a component-embedded substrate comprising: said insulating layer formed by said insulating substrate cured; said component that is embedded in said insulating layer and bonded to said metal layer by said adhesive layer; said conductive pattern formed on a surface of said insulating layer; said adhesive layer having said first adhesive body at the position corresponding to said terminal; and a conductive via formed by depositing a plating on said via penetrating through said metal layer and said adhesive layer, so that the conductive via electrically connects said conductive pattern and said terminal to each other.

Preferably, said first adhesive body and said second adhesive body are made of an epoxy resin or a polyimide resin.

Preferably, a total thickness of said first adhesive body and said second adhesive body is 10 µm to 120 µm.

Preferably, a glass transition temperature of said first adhesive body is 40 °C to 200 °C (in a TMA method), and a glass transition temperature of said second adhesive body is equal to or higher than the glass transition temperature of said first adhesive body and falls within the range of 40 °C to 200 °C (in the TMA method).

Preferably, said first adhesive body has a thickness of 5 µm to 60 µm, and said second adhesive body has a thickness of 5 µm to 60 µm.

### Advantageous Effects of the Invention

According to the present invention, since the first adhesive body is previously formed and cured at the position corresponding to the protrusion of the component in the adhesive layer forming step, and the component is then mounted with the protrusion thereof aligned with the first adhesive body in the component mounting step, the protrusion and the first adhesive body abut against each other, and any second adhesive body between the two is squeezed out to flow to the other part of the component than the protrusion. As a result, the component main body recessed with respect to the protrusion is filled with the second adhesive body, and void formation in the adhesive layer can be prevented. In particular, even if the component to be embedded has recesses and projections, void formation can be prevented with reliability. That is, the possibility that the recessed part of the component main body contains a void can be avoided, and even the recessed part can be filled with the adhesive layer to prevent void formation. In addition, since the adhesive layer is formed by the plurality of adhesive bodies, the amount of the adhesive applied in one application can be reduced, which also makes a contribution to the void reduction. The reduction of the amount of the applied adhesive allows the adhesive layer to be formed with stability and the thickness of the entire adhesive layer to be controlled with stability and precision. This improves the insulation properties, allows precise shaping of any via, improves the heat resistance, and improves the reliability of the product as a whole. As an alternative, the adhesive layer may have a three or more layer structure further comprising a third adhesive body or the like. The structure of the adhesive layer can be determined by appropriately setting the number of printings and curings of adhesive bodies by taking into consideration the shape of the component or the amounts of the applied adhesive bodies.

Since the second adhesive body, which is formed in an area corresponding to the whole of the surface of the component facing the adhesive layer, is formed in such an area that contains the first adhesive body, the adhesive layer has the projection part formed by the first adhesive body. As a result, the adhesive layer has the projection part and the recess part, and the projection part abuts against the protrusion of the component. When the projection part and the protrusion abut against each other, the second adhesive body is squeezed out from between the projection part and the protrusion to flow into the recess part with reliability. Since the recess part faces the recessed part of the component, which is the other part than the protrusion, the second adhesive body can flow into the space between the recess part of the adhesive layer and the recessed part of the component with reliability to prevent void formation. That is, the present invention essentially consists in that the cured first adhesive body is provided at the position corresponding to the protrusion of the component, and the cured first adhesive body abuts against the protrusion to squeeze out the second adhesive body to flow. The flow of the second adhesive body is used to prevent void formation with reliability. To achieve this, the projection part of the adhesive layer and the protrusion of the component are configured to abut against each other, and the recess part of the adhesive layer and the recessed part of the component are formed at corresponding positions.

The first adhesive body and the second adhesive body may be made of the same material or of different materials. The material(s) of the adhesive bodies can be appropriately chosen taking into consideration the cost, the ease of application, the adhesive properties, the insulation properties or the like. It is ascertained that the void reduction effect is provided even if the adhesive bodies are made of the same material.

The insulating substrate preferably has a coefficient of thermal expansion close to that of the component. This allows the behavior of the insulating substrate to be close to that of the component in a high-temperature environment, whereby the thermal load, such as the internal stress, can be reduced, and the connection reliability can be more effectively improved.

With the component-embedded substrate according to the present invention, the conductive via is formed from the side of the adhesive layer, which forms the component mounting surface. As a result, all conductive vias extending from the conductive pattern to the component can have the same depth regardless of the height of the component. Therefore, machining for via formation is simple, and the formability of the vias can be equalized, so that a steady connection reliability can be achieved.

### Brief Description of Drawings

FIG. 1 is a schematic diagram showing a step of a method of manufacturing a component-embedded substrate according to the present invention.
FIG. 2 is a schematic diagram showing a step of the method of manufacturing a component-embedded substrate according to the present invention.
FIG. 3 is a schematic diagram showing a step of the method of manufacturing a component-embedded substrate according to the present invention.
FIG. 4 is a schematic diagram showing a step of the method of manufacturing a component-embedded substrate according to the present invention.
FIG. 5 is a schematic diagram showing a step of the method of manufacturing a component-embedded substrate according to the present invention.
FIG. 6 is a schematic diagram showing a step of the method of manufacturing a component-embedded substrate according to the present invention.
FIG. 7 is a schematic diagram showing a step of the method of manufacturing a component-embedded substrate according to the present invention.
FIG. 8 is a schematic diagram showing a component-embedded substrate according to the present invention.
FIG. 9 is a schematic diagram showing another component-embedded substrate according to the present invention.

### Mode for Carrying out the Invention

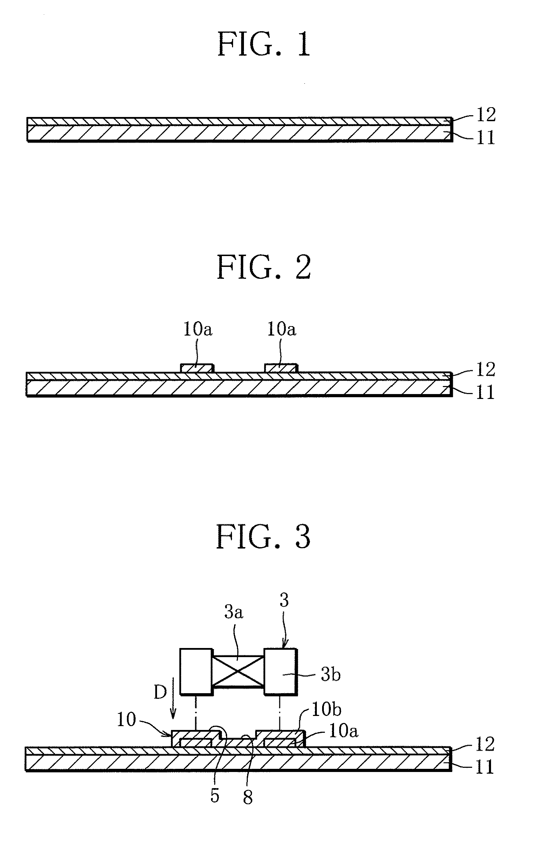

As shown in FIGS. 1 to 3, a method of manufacturing a component-embedded substrate according to the present invention begins with an adhesive layer forming step. First, for example, a supporting plate 11 with a metal layer 12 formed thereon is prepared as shown in FIG. 1. The supporting plate 11 has a rigidity required by a process condition. The supporting plate 11 is formed by a stainless steel (SUS) plate, an aluminum plate or the like that has a rigidity as a supporting substrate. In the case where the supporting plate 11 is a SUS plate, for example, the metal layer 12 is a deposited copper plating foil having a predetermined thickness. In the case where the supporting plate 11 is an aluminum plate, the metal layer 12 is a copper foil applied to the supporting plate 11.

As shown in FIG. 2, a first adhesive body 10a is then applied onto the metal layer 12 with a dispenser or by printing, for example. Once the first adhesive body 10a is cured, a second adhesive body 10b is applied as shown in FIG. 3. The second adhesive body 10b is also applied with a dispenser or by printing. The adhesives are preferably applied to a thickness of approximately 5 µm to 60 µm in one application, although the present invention is not limited thereto. That is, the first and second adhesive bodies preferably have a thickness of 5 µm to 60 µm, and an optimal thickness of an adhesive layer 10, which comprises the first and second adhesive bodies, is approximately 10 µm to 120 µm, although the present invention is not limited thereto. By forming each adhesive layer 10 as described above, adhesive layers 10 can have a uniform height, so that components 3 can be precisely positioned in the height direction.

Both the first adhesive body 10a and the second adhesive body 10b are made of an epoxy resin or a polyimide resin. The first adhesive body 10a and the second adhesive body 10b form the adhesive layer 10 in the above described way. Note that the first adhesive body 10a and the second adhesive body 10b may be made of the same material or of different materials. The material(s) of the adhesive bodies can be appropriately chosen taking into consideration the cost, the ease of application, the adhesive properties, the insulation properties or the like. It is ascertained that the void reduction effect is provided even if the adhesive bodies are made of the same material.

As shown in FIG. 3, an electric or electronic component 3 (for example, a chip passive component, such as a chip capacitor or a resistor) to which the method of manufacturing a component-embedded substrate according to the present invention is applied has a component main body 3a and a protrusion 3b that protrudes beyond the component main body 3a (a terminal 4 in the example shown in the drawings). That is, the component 3 to be embedded has a part protruding toward the adhesive layer 10. The first adhesive body 10a is formed only at a position corresponding to the protrusion (the terminal 4). After the first adhesive body 10a is cured, the second adhesive body 10b described above is formed in an area corresponding to the whole of the surface of the component 3 facing the adhesive layer 10.

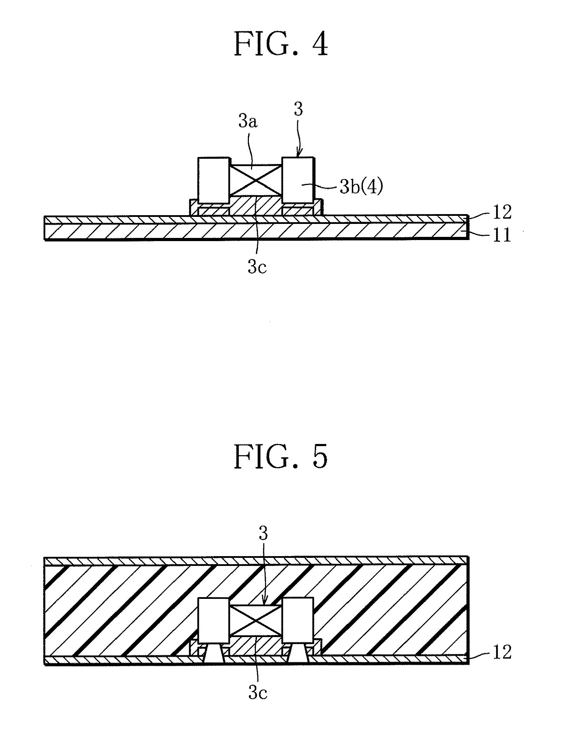

A component mounting step of mounting the component 3 on the adhesive layer 10 is then performed as shown in FIGS. 3 and 4. This step begins with moving the component 3 in the direction of the arrow D shown in FIG. 3. And the component 3 is mounted on the adhesive layer 10 with the protrusion 3b aligned with the first adhesive body 10a as shown in FIG. 4.

Since the first adhesive body 10a is previously formed and cured at the position corresponding to the protrusion 3b of the component 3 in the adhesive layer forming step, and the component 3 is then mounted with the protrusion 3b thereof aligned with the first adhesive body 10a in the component mounting step, the protrusion 3b and the first adhesive body 10a abut against each other, and any second adhesive body 10b between the two is squeezed out to flow to the other part of the component 3 than the protrusion 3b (that is, a part 3c of the component main body 3a that is recessed with respect to the protrusion 3b (the terminal 4)). As a result, the part 3c of the component 3 recessed with respect to the protrusion 3b is filled with the second adhesive body 10b, and void formation in the adhesive layer 10 can be prevented. In particular, even if the component 3 to be embedded has recesses and projections, void formation can be prevented with reliability.

That is, the possibility that the recessed part 3c of the component main body contains a void can be avoided, and even the recessed part 3c can be filled with the adhesive layer 10 to prevent void formation. In addition, since the adhesive layer 10 is formed by the plurality of adhesive bodies 10a and 10b, the amount of the adhesive applied in one application can be reduced, which also makes a contribution to the void reduction. The reduction of the amount of the applied adhesive allows the adhesive layer 10 to be formed with stability and the thickness of the entire adhesive layer 10 to be controlled with stability and precision. This improves the insulation properties, allows precise shaping of any via, improves the heat resistance, and improves the reliability of the product as a whole. As an alternative, the adhesive layer 10 may have a three or more layer structure further comprising a third adhesive body or the like. The structure of the adhesive layer 10 can be determined by appropriately setting the number of printings and curings of adhesive bodies by taking into consideration the shape of the component 3 or the amounts of the applied adhesive bodies.

Referring to FIG. 3, in particular, the first adhesive body 10a of the adhesive layer 10 projects upward to form a projection part 5, and the part of the adhesive layer 10 formed by the second adhesive body 10b alone forms a recess part 8. This is because the second adhesive body 10b is applied over the cured first adhesive body 10a with a dispenser or by printing, for example.

The adhesive layer 10 has the projection part 5 formed by the first adhesive body 10a. As a result, the adhesive layer 10 has the projection part 5 and the recess part 8, and the projection part 5 abuts against the protrusion 3b of the component 3. When the projection part 5 and the protrusion 3b abut against each other, the second adhesive body 10b is squeezed out from between the projection part 5 and the protrusion 3b to flow into the recess part 8 with reliability. Since the recess part 8 faces the recessed part 3c of the component, which is the other part than the protrusion, the second adhesive body 10b can flow into the space between the recess part 8 and the recessed part 3c with reliability to prevent void formation. That is, the present invention essentially consists in that the cured first adhesive body 10a is provided at the position corresponding to the protrusion 3b of the component 3, and, when the first adhesive body 10a abuts against the protrusion 3b, the second adhesive body 10b is squeezed out to flow, because the first adhesive body 10a has already cured then. The flow of the second adhesive body 10b is used to prevent void formation with reliability. To achieve this, the projection part 5 of the adhesive layer 10 and the protrusion 3b of the component 3 are configured to abut against each other, and the recess part 8 of the adhesive layer 10 and the recessed part 3c of the component 3 are formed at corresponding positions. Note that a plurality of components 3 can be mounted. In that case, the same number of adhesive layers 10 as the number of components 3 are formed.

After the component mounting step described above is performed, a laminating step, a via forming step, a plating step and a patterning step are performed.

The laminating step is to laminate an insulating substrate, which is to serve as an insulating layer 2 for the component 3, to embed the component 3 in the insulating substrate. This step involves laying up an insulating substrate, such as a prepreg, on the side of the component 3 opposite to the side facing the metal layer 12 and heating and pressing the insulating substrate in a vacuum. A vacuum pressing machine is used to achieve the press, for example. The insulating substrate preferably has a coefficient of thermal expansion close to that of the component 3. After the layer is laminated, the supporting plate 11 is removed. The metal layer 12 is laminated on one surface of the insulating layer 2, and another metal layer 13 is laminated on the other surface of the insulating layer 2.

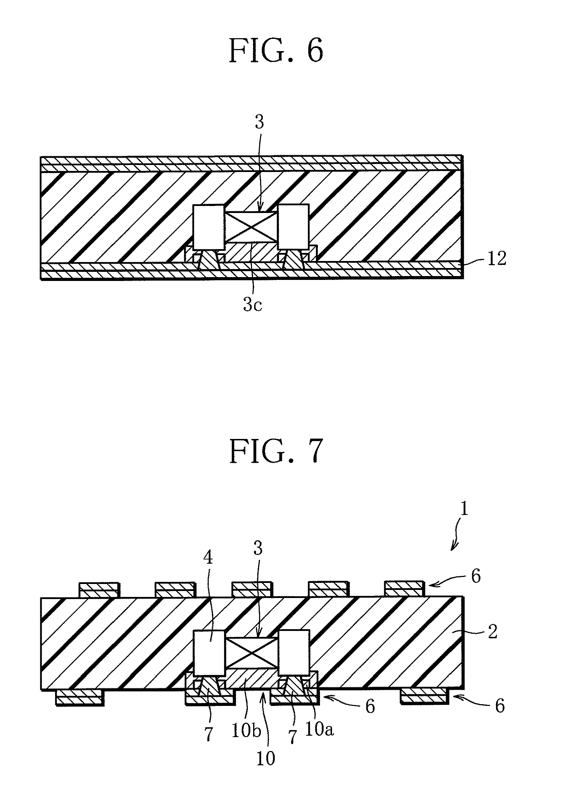

Subsequently, the via forming step is performed. This step is to form a via 13 by piercing with a laser beam or the like, as shown in FIG. 5. More specifically, the via 13 is formed to extend from the metal layer 12 to the terminal 4 through the adhesive layer 10. Depending on the structure, a conductive through-hole or other conductive vias that provides an interlayer electrical connection or an electrical connection between the top and the bottom of the component-embedded substrate may be formed at this point in time. After the via is formed, a desmear processing is performed to remove any resin remaining in the via forming process. As shown in FIG. 6, a plating processing (to provide a conductivity) is then performed to deposit a plating on the inside of the via 13 to provide a conductive via 7. A conductive layer forming step is then performed. This step involves forming conductive layers by forming a conductive pattern 6 on both surfaces of the insulating layer 2, as shown in FIG. 7, by etching or the like.

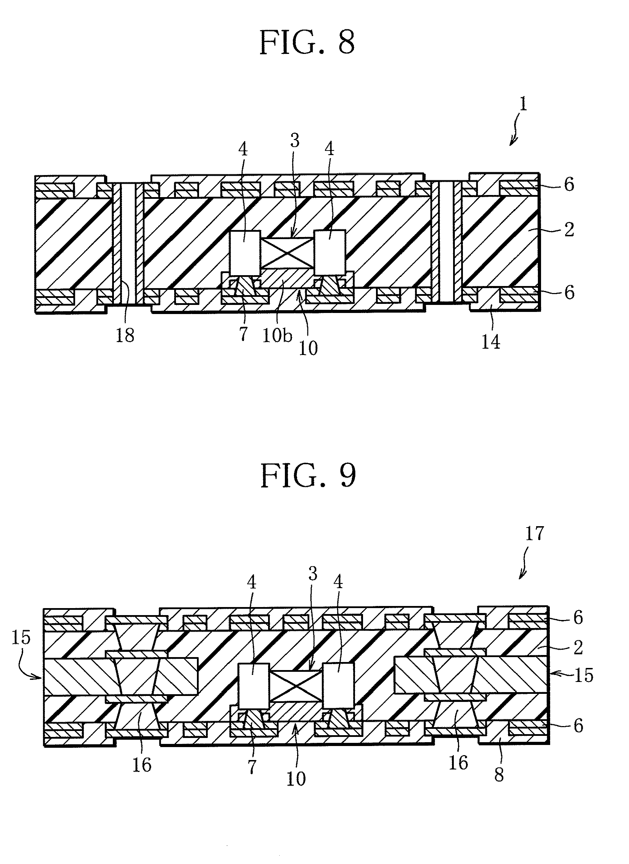

For example, if a through-hole is formed on both sides of the component 3 in the via forming step described above, the through-holes plated in the plating processing form conductive through-holes 18. A solder resist 14 is formed at a predetermined position. In this way, a component-embedded substrate 1 shown in FIG. 8 is manufactured.

The component-embedded substrate 1 manufactured through the steps described above comprises the insulating layer 2, the component 3, the conductive patterns 6, the adhesive layer 10 and the conductive via 7 as shown in FIG. 7. The insulating layer 2 is the cured insulating substrate (e.g. the prepreg or the like) described above, and the component 3 is bonded to the metal layer 12 (the conductive pattern 6 including the metal layer 12) by the adhesive layer 10. The conductive patterns 6 are formed on the surfaces of the insulating layer 2, and the first adhesive body 10a of the adhesive layer 10 is formed at a position corresponding to the terminal 4 of the component 3. The conductive via 7 electrically connects the conductive patterns and the terminal 4 to each other.

A substrate 17 shown in FIG. 9 can be formed if not only the insulating layer 2 but also a circuit board 15 including a conductive circuit, a conductive via or a conductive through-hole or a combination thereof is disposed at the side of the component 3 in the laminating step described above, and a connection conductive via 16 that electrically connects the conductive layers 6 and the circuit board 15 is formed in the conductive via forming step. The substrate 17 is a so-called four-layer substrate. The connection via 16 may be a filled via, for example. The connection established by the connection via 16 may be of an any-layer structure.

### Explanation of Reference Signs

- 1: component-embedded substrate
- 2: insulating layer
- 3: component
- 3a: component main body
- 3b: protrusion
- 3c: recessed part
- 4: terminal
- 5: projection part
- 6: conductive pattern
- 7: conductive via
- 8: recess part
- 10: adhesive layer
- 10a: first adhesive body
- 10b: second adhesive body
- 11: supporting plate
- 12: metal layer
- 13: via
- 14: solder resist
- 15: circuit board
- 16: connection via
- 17: substrate
- 18: conductive through-hole

## Claims

1. A method of manufacturing a component-embedded substrate, comprising:
an adhesive layer forming step of forming an adhesive layer on a metal layer formed on a supporting plate; and
a component mounting step of mounting an electric or electronic component on said adhesive layer,
wherein said component includes a component main body and a protrusion that protrudes beyond the component main body toward said adhesive layer;
the adhesive layer formed in said adhesive layer forming step includes at least a first adhesive body and a second adhesive body, said first adhesive body is formed only at a position corresponding to said protrusion, the second adhesive body is formed in an area corresponding to the whole of the surface of said component facing said adhesive layer after said first adhesive body is cured, a part of said adhesive layer formed by said first adhesive body is a projection part, a part of said adhesive layer formed by said second adhesive body alone is a recess part, which has a lower height than said projection part; and
said component is mounted with said protrusion aligned with said first adhesive body in said component mounting step.

2. The method of manufacturing a component-embedded substrate according to claim 1, wherein said first adhesive body and said second adhesive body are made of a same material.

3. The method of manufacturing a component-embedded substrate according to claim 1, wherein said first adhesive body and said second adhesive body are made of different materials.

4. The method of manufacturing a component-embedded substrate according to claim 1, wherein said protrusion is a terminal, and
the method further comprises:
a laminating step of laminating an insulating substrate, which is to serve as an insulating layer for said component, to embed said component in said insulating substrate, the layer stacking step being performed after said component mounting step;
a via forming step of removing said supporting plate and forming a via that penetrates through said metal layer and said adhesive layer and reaches said terminal;
a plating step of depositing a plating on a surface of said metal layer and a surface of said via; and
a patterning step of forming a conductive pattern including said metal layer.

5. The method of manufacturing a component-embedded substrate according to claim 1, wherein said supporting plate used in said adhesive layer forming step is an aluminum plate, and said metal layer is a copper foil applied to said aluminum plate.

6. The method of manufacturing a component-embedded substrate according to claim 1, wherein said supporting plate used in said adhesive layer forming step is a stainless steel plate, and said metal layer is a copper plating foil deposited on said stainless steel plate.

7. The method of manufacturing a component-embedded substrate according to claim 1, wherein a plurality of either or both of semiconductor components having a plurality of electrodes and passive components having a plurality of electrodes are mounted in said component mounting step.

8. The method of manufacturing a component-embedded substrate according to claim 4, wherein not only said insulating layer but also a circuit board including a conductive circuit, a conductive via or a conductive through-hole or a combination thereof is disposed at a side of said component in said laminating step, and
a connection via that electrically connects said conductive layer and said circuit board to each other is formed in said via forming step.

9. The method of manufacturing a component-embedded substrate according to claim 8, wherein said connection via formed in said via forming step is a filled via.

10. The method of manufacturing a component-embedded substrate according to claim 8, wherein a connection provided by said connection via formed in said via forming step is of an any-layer structure.

11. The method of manufacturing a component-embedded substrate according to claim 8, wherein said connection via formed in said via forming step has a diameter equal to or larger than a diameter of said via.

12. A component-embedded substrate manufactured by the method of manufacturing component-embedded substrate according to claim 4, comprising:
said insulating layer formed by said insulating substrate cured;
said component that is embedded in said insulating layer and bonded to said metal layer by said adhesive layer;
said conductive pattern formed on a surface of said insulating layer;
said adhesive layer having said first adhesive body at the position corresponding to said terminal; and
a conductive via formed by depositing said plating on said via penetrating through said metal layer and said adhesive layer, so that the conductive via electrically connects said conductive pattern and said terminal to each other.

13. The component-embedded substrate according to claim 12, wherein said first adhesive body and said second adhesive body are made of an epoxy resin or a polyimide resin.

14. The component-embedded substrate according to claim 12, wherein a total thickness of said first adhesive body and said second adhesive body is 10 µm to 120 µm.

15. The component-embedded substrate according to claim 12, wherein a glass transition temperature of said first adhesive body is 40 °C to 200 °C (in a TMA method), and
a glass transition temperature of said second adhesive body is equal to or higher than the glass transition temperature of said first adhesive body and falls within the range of 40 °C to 200 °C (in the TMA method).

16. The component-embedded substrate according to claim 12, wherein said first adhesive body has a thickness of 5 µm to 60 µm, and said second adhesive body has a thickness of 5 µm to 60 µm.
